# EUROPÄISCHE PATENTSCHRIFT

(11) **EP 2 332 193 B1**
(45) Veröffentlichungstag und Bekanntmachung des Hinweises auf die Patenterteilung: **03.06.2015**
(21) Anmeldenummer: 09780303.5
(22) Anmeldetag: 08.07.2009
(51) Int. Cl.: H01L 41/25, H01L 41/313, H02N 2/18

(54) **VERFAHREN ZUR HERSTELLUNG MINDESTENS EINES MECHANISCH-ELEKTRISCHEN ENERGIEWANDLERSYSTEMS UND MECHANISCH-ELEKTRISCHES ENERGIEWANDLERSYSTEM**
METHOD FOR PRODUCING AT LEAST ONE MECHANICAL-ELECTRICAL ENERGY CONVERSION SYSTEM AND MECHANICAL-ELECTRICAL ENERGY CONVERSION SYSTEM
PROCÉDÉ DE FABRICATION D'AU MOINS UN SYSTÈME DE CONVERSION D'ÉNERGIE MÉCANOÉLECTRIQUE ET SYSTÈME DE CONVERSION D'ÉNERGIE MÉCANOÉLECTRIQUE

(30) Priorität: 02.09.2008 DE 102008041755
(43) Veröffentlichungstag der Anmeldung: 15.06.2011
(73) Patentinhaber: Robert Bosch GmbH, 70442 Stuttgart (DE)
(72) Erfinder: LAERMER, Franz, 71263 Weil der Stadt (DE); PANNEK, Thorsten, 70176 Stuttgart (DE); REICHENBACH, Ralf, 73732 Esslingen (DE); KECK, Marian, 71083 Herrenberg (DE)
(86) Internationale Anmeldenummer: PCT/EP2009/058655
(87) Internationale Veröffentlichungsnummer: WO 2010/025975

(56) Entgegenhaltungen:
- WO-A-99/08330
- WO-A-2004/030949
- DE-A1-102007 006 994
- US-A- 5 572 081
- US-A1- 2008 074 002

## Beschreibung

### Stand der Technik

Drahtlose elektronische Geräte finden eine immer weitere Verbreitung. Problematisch ist allerdings bei derartigen Geräten die Energieversorgung, die meist über eine Batterie oder einen Akku gewährleistet wird. Diese sind oft groß und schwer und müssen ersetzt oder nachgeladen werden.

Bei Anwendungen mit niedrigem Stromverbrauch können andere kleinere und langlebigere Energiequellen in Betracht gezogen werden, wie z. B. das so genannte "Power Harvesting". Dabei wird Umgebungsenergie z. B. in Form von Vibrationen durch mechanisch-elektrische Wandlung in elektrische Energie umgewandelt. Ein solcher Wandler ist z. B. in der Druckschrift DE 10 2007 006 994 A1 beschrieben. Insbesondere ist der in dieser Druckschrift beschriebene Wandler als Biegewandler ausgeführt. Der Biegewandler umfasst ein piezoelektrisches Element, das in der Mitte eines biegebalkenförmigen Abschnitts einer elastischen Trägerstruktur angeordnet ist. Über sich auf der Unter- und Oberseite des piezoelektrischen Elements befindliche Elektroden kann die Spannung abgegriffen werden, die durch Verformung des piezoelektrischen Elements durch Schwingen der Trägerstruktur aufgebaut wird. Ein derartiger Biegewandler lässt sich beispielsweise als Stromversorgung in einem drahtlosen Sensormodul, beispielsweise ein Sensormodul zum Messen eines Reifeninnendruckes, verwenden.

Bei Energiewandlersystemen dieser Art handelt es sich um komplexe makromechanische Baugruppen mit Abmessungen im Millimeter- bis Zentimeterbereich, deren Zusammenbau extrem aufwendig und zeitintensiv ist. Insbesondere müssen fast alle Einzelteile, aus denen sich das Energiewandlersystem zusammensetzt, extrem passgenau mit geringen Toleranzen zueinander positioniert werden. Dies hat in der Regel hohe AVT-Kosten (Aufbau- und Verbindungstechnik) zur Folge. Eine günstige AVT ist für die Herstellung eines derartigen Energiewandlersystems existenziell, um auch bei Anwendungen, bei denen alternativ auch eine Batterie eingesetzt werden könnte, keinen Kostennachteil zu erzeugen.

Aus der Schrift US 5,572,081 A ist ein Beschleunigungssensor bekannt, bei dem eine seismische Masse mit zugeordneten piezoelektrischen Elementen zwischen zwei Halterungen angebracht ist. Zur Arretierung werden die Halterungen und die dazwischen befindliche seismische Masse mit einem Klemmring umschlossen.

### Offenbarung der Erfindung

Die Erfindung schlägt ein Verfahren zur Herstellung eines oder mehrerer mechanischelektrischer Energiewandlersysteme aus mehreren Einzelteilen gemäß Anspruch 1 vor. Es werden zumindest zwei Einzelteile in einer Montagevorrichtung positioniert und die mindestens zwei Einzelteile in der Montagevorrichtung in den Einzelteilen zugeordneten Fügebereichen zusammengefügt, wobei ein Einzelteil mindestens ein piezoelektrisches Element, eine Trägerstruktur, eine seismische Masse und/oder ein Elektrodenelement umfasst. Die Trägerstruktur und das piezoelektrische Element werden mit einem elektrisch leitenden Klebemittel und einem elektrisch nicht leitenden Klebemittel zusammengefügt.

Erfindungsgemäß ist damit eine kostengünstige Herstellung eines oder mehrerer Energiewandlersysteme bei gleichzeitiger Einhaltung der Anforderungen einer hohen Genauigkeit sowie geringem Montagezeitaufwand möglich.

Des weiteren sieht die Erfindung einen mechanisch-elektrisches Energiewandlersystems vor, das hergestellt ist durch ein Verfahren nach einem der Ansprüche 1 bis 17.

### Kurze Beschreibung der Zeichnungen

Die Erfindung wird im Folgenden anhand von Ausführungsbeispielen, die durch mehrere Figuren dargestellt sind, näher beschrieben. Dabei zeigt:
- Fig. 1: eine erste Ausführungsform einer erfindungsgemäßen Montagevorrichtung,
- Fig. 2: die Montagevorrichtung mit einem darin eingesetzten ersten Einzelteil, hier einer seismischen Masse,
- Fig. 3: ein zweites Einzelteil, das eine Trägerstruktur umfasst,
- Fig. 4: die Montagevorrichtung mit darin positioniertem zweiten Einzelteil,
- Fig. 5: die Montagevorrichtung mit einem darin positioniertem Abstandsmittel,
- Fig. 6: ein piezoelektrisches Element, auf dessen Fügebereiche ein Klebemittel aufgetragen ist,
- Fig. 7: die Montagevorrichtung mit darin positioniertem piezoelektrischem Element,
- Fig. 8: die Montagevorrichtung und ein erstes Presselement,
- Fig. 9: einen aus seismischer Masse, zweitem Einzelteil und piezoelektrischem Element zusammengefügten Stapel mit Abstandsmittel,
- Fig. 10: genannten Stapel ohne Abstandsmittel,
- Fig. 11: ein drittes Einzelteil, das ein Elektrodenelement umfasst,
- Fig. 12: das dritte Einzelteil mit auf dessen Fügebereiche aufgetragenen Klebemittel,
- Fig. 13: einen seismischer Masse, zweitem Einzelteil und drittem Einzelteil zusammengefügten Stapel,
- Fig. 14: eine Ansicht des fertigen Energiewandlersystems, und

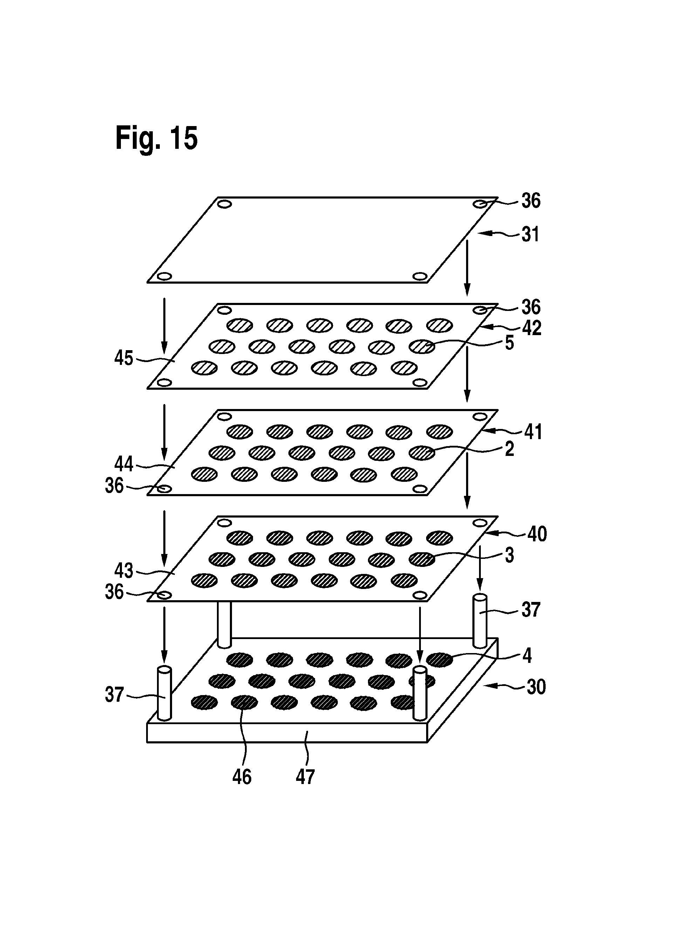

- Fig. 15: eine zweite Ausführungsform einer erfindungsgemäßen Montagevorrichtung mit in der zweiten Montagevorrichtung positionierbaren zweiten Ausführungsformen der Einzelteile und einer zweiten Ausführungsform des Presselementes.

Gleiche oder einander entsprechende Teile sind in den Figuren mit denselben Bezugszeichen versehen.

### Ausführungsformen der Erfindung

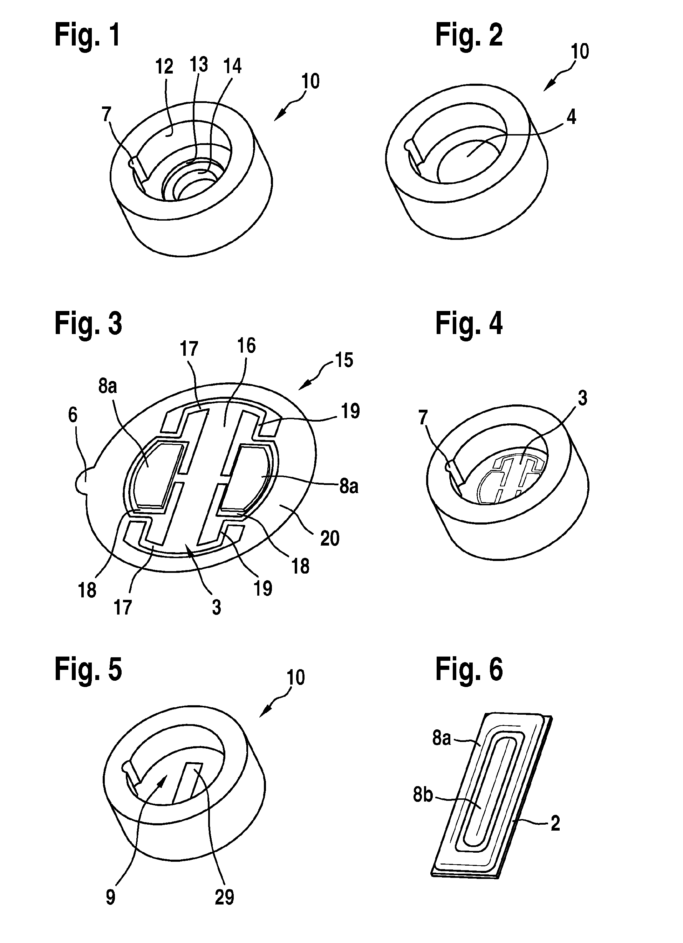

Die Figuren 1 bis 14 illustrieren eine erste Ausführungsform des erfindungsgemäßen Verfahrens zur Herstellung eines oder mehrerer mechanischelektrischer Energiewandlersysteme aus mehrere Einzelteilen.

Figur 1 zeigt die in diesem Verfahren verwendete erste Ausführungsform einer Montagevorrichtung 10. Die Montagevorrichtung 10 besteht aus einem zylinderförmigen, massiven Körper. Der zylinderförmige Körper weist eine durchgehende Bohrung auf, die durch drei Abschnitte 12, 13, 14 gebildet wird. Die Abschnitte 12, 13, 14 sind nacheinander folgend entlang der Symmetrieachse des zylinderförmigen Körpers angeordnet. Auf den ersten, breitesten Abschnitt 12 mit dem größten Durchmesser folgt der schmal ausgebildete zweite Abschnitt 13 mit etwas kleinerem Durchmesser, und dann der dritte Abschnitt 14, der den geringsten Durchmesser aufweist. Im ersten Abschnitt 12 ist eine Nut 7 vorgesehen, die als Positionierhilfegegenstück zu einer Positionierhilfe 6 der Einzelteile, die später erläutert wird, ausgebildet ist.

In die Montagevorrichtung 10 wird ein erstes Einzelteil, das durch eine seismische Masse 4 gebildet wird, eingelegt, siehe Fig. 2. Die seismische Masse 4, die scheibenförmig mit planparalleler Unter- und Oberseite ausgebildet ist, wird dabei auf die durch den Übergang vom zweiten Abschnitt zum dritten Abschnitt 14 des Montagekörpers 10 gebildete Stufe ausgesetzt. Der zweite Abschnitt 13 entspricht im Durchmesser und seiner Breite dem Durchmesser bzw. der Höhe der scheibenförmigen seismischen Masse 4, so dass die positionierte seismische Masse 4 bündig mit der Kante zwischen erstem Abschnitt 12 und zweitem Abschnitt 13 abschließt.

Nachfolgend wird auf die durch seismische Masse 4 und Montagevorrichtung 10 gebildete plane Oberfläche ein zweites Einzelteil 15 in der Montagevorrichtung 10 positioniert, siehe Figuren 3, 4. Das zweite Einzelteil 15 weist eine kreisförmige Außenkontur auf, die an einer Stelle eine als Positionierhilfe dienende Justagenase 6 ausbildet. Der Durchmesser des zweiten Einzelteils 15 entspricht dem Durchmesser des ersten Abschnitts 12, die Justagenase 6 ist komplementär zum Profil der Nut 7 der Montagevorrichtung 10 ausgebildet. Auf diese Weise wird eine passgenaue Positionierung des ersten Einzelteils 15 in der Montagevorrichtung 10 gewährleistet.

Das zweite Einzelteil umfasst eine Trägerstruktur 3. Die Trägerstruktur 3 unterteilt sich in einen balkenförmigen Abschnitt 16, dessen Enden durch einen sichelförmigen Lagerabschnitt 17 abgeschlossen werden, und von dessen Mitte über zwei Stege zwei flügelförmige Befestigungsabschnitte 18 abgehen. Über Stege 19 wird die Trägerstruktur 3 an einem Rahmen 20, der die zuvor beschriebene Außenkontur des Einzelteils 15 ausbildet, gehalten. Neben der Funktion, die Trägerstruktur 3 korrekt zu positionieren, besitzt damit der Rahmen 20 eine Schutzfunktion.

Das erste Einzelteil 15 ist mittels Laserbearbeitung aus einem Vollblech herausgearbeitet. Das Blech selbst ist ein Federblech, das elastisch deformierbar und elektrisch leitfähig ist.

Auf die flügelförmigen Abschnitte 18 der Trägerstruktur 3 wird ein nicht elektrisch leitender Klebstoff 8a aufgetragen. Das Einzelteil 15 wird dann in der Montagevorrichtung 10 positioniert, wobei das Klebemittel 8a der seismischen Masse 4 zugewandt ist. Über das Klebemittel 8a werden seismische Masse 4 und Trägerstruktur 3 zusammengefügt, die durch Klebemittel bedeckten Flächen bilden die Fügebereiche aus.

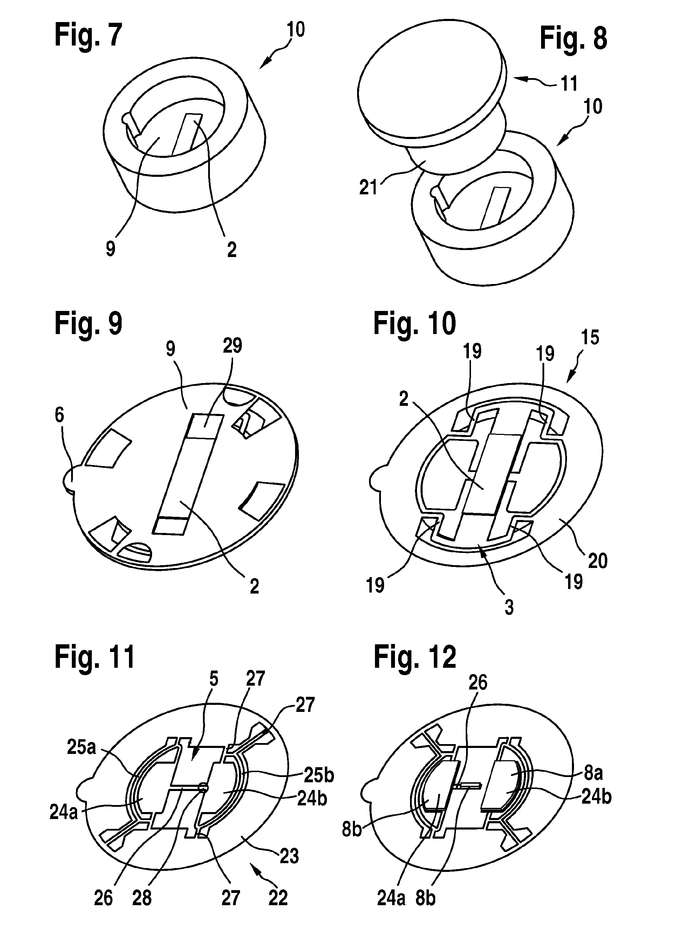

Als nächstes wird ein Abstandsmittel 9, siehe Figuren 5 und 9, in der Montagevorrichtung 10 positioniert. Das Abstandsmittel 9 ist wie das erste Einzelteil 15 aus einem Vollblech durch Laserbearbeitung herausgearbeitet, d.h. als Abstandsblech 9 ausgebildet, und weist eine entsprechende Außenkontur und Justagenase 6 auf. Im Zentrum ist ein rechteckförmiger Ausschnitt 20 vorgesehen, der in seiner Breite und Länge den balkenförmigen Abschnitt 16 der Trägerstruktur 3 entspricht.

Im nächsten Schritt wird ein Presselement 11, vergleiche Figur 8, in die Montagevorrichtung 10 eingeführt, und durch Druckausübung zweites Einzelteil 15 und seismische Masse 4 aneinander gepresst. Das Presselement 11 ist dabei in Form eines Deckels der Montagevorrichtung 10 mit einem zylinderförmigen Pressstempel 21 ausgebildet. Der zylinderförmige Pressstempel 21 entspricht in seinem Durchmesser dem Durchmesser des ersten Abschnitts 12 der Montageeinrichtung 10, und weist eine ebene Stempelfläche auf. Das Presselement 11 erlaubt damit eine gleichmäßige Druckverteilung sowie eine genaue Druckdosierung (beispielsweise durch Auflegen definierter Gewichte auf das Presselement 11). Nach dem Aneinanderpressen wird das Presselement 11 aus der Montagevorrichtung 10 entfernt.

In einem folgenden Schritt, siehe Figur 6, wird bei einem dritten Einzelteil, hier ein piezoelektrisches Element 2, Klebemittel 8a, 8b auf dessen Unterseite aufgetragen. Das piezoelektrische Element 2 ist streifenförmig mit einer Breite entsprechend der Breite des balkenförmigen Abschnitts 16 der Trägerstruktur 3 aus einer piezoelektrischen Keramik ausgebildet. Das piezoelektrische Element 2 ist an seiner Ober- und Unterseite mit einer hier nicht sichtbaren Metallbeschichtung versehen, die als Elektroden zum Abgreifen der vom piezoelektrischen Element 2 erzeugten Spannung dienen. Das erste Klebemittel 8a ist ein nichtelektrisch leitender Kleber 8a, der am Außenrand der Unterseite des piezoelektrischen Elementes 2 aufgetragen wird, das zweite Klebemittel 8b ein elektrisch leitfähiger Kleber 8b, der im Innenbereich auf der Unterseite des piezoelektrischen Elementes 2 aufgetragen wird. Dieser "Dual-Klebstoffprozess" verhindert, dass insbesondere beim Zusammenfügen der leitfähige Kleber 8b in ungewünschte Bereiche vordringt, insbesondere zu einem Kurzschluss führt.

Das piezoelektrische Element 2 mit darauf aufgetragenem Kleber 8a, 8b wird in der Montagevorrichtung 10 in den rechteckförmigen Ausschnitt 29 des Abstandsmittels 9 in dessen Mitte positioniert, siehe Figur 7 und Figur 9. Die Unterseite mit dem Klebstoff 8a, 8b ist dabei dem zweiten Einzelteil 15, insbesondere dem balkenförmigen Abschnitt 16, zugewandt.

Nach dem Einsetzen des piezoelektrischen Elementes 2 in die Montagevorrichtung 10 wird der aus seismischer Masse 4, zweitem Einzelteil 15, Abstandsmittel 9 und piezoelektrischem Element 2 gebildete Stapel durch das Presselement 11 durch Aneinanderpressen zusammengefügt, wie oben schon beschrieben. Das Abstandsmittel 9 gewährleistet, dass das piezoelektrische Element 2 einen Mindestabstand zur Trägerstruktur 3, insbesondere zum balkenförmigen Abschnitt 16 aufweist, wodurch verhindert wird, dass zu viel Klebstoff 8a, 8b beim Aneinanderpressen herausgepresst wird und zur Funktionsuntüchtigkeit des herzustellenden Energiewandlersystems führt. Entsprechend ist die Dicke des Abstandsmittels 9 größer gewählt als die des piezoelektrischen Elementes 2.

Das Presselement 11 wird durch hier nicht gezeigte Halteklammern an der Montagevorrichtung 10 befestigt und dann der Kleber 8a, 8b in einem Ofen ausgeheizt.

Nach dem Ausheizen des Klebers wird der Stapel seismische Masse 4-zweites Einzelteil 15 - piezoelektrisches Element 2 - Abstandsmittel 9 aus der Montagevorrichtung 10 entnommen. Für die Entnahme kann die durch den dritten Abschnitt 14 gebildete rückseitige Öffnung der Montagevorrichtung 10 genutzt werden, über die der genannte Stapel aus der Montagevorrichtung 10 herausgedrückt werden kann, insbesondere unter zur Hilfenahme eines beispielsweise stabförmig ausgebildeten Elementes, das durch den dritten Abschnitt 14 hindurchgeführt wird. Nach dem Herausnehmen des Stapels wird das Abstandsmittel 9 abgehoben, siehe Figur 9.

In einem nächsten Schritt, siehe Figur 10, wird die Trägerstruktur 3 freigestellt, indem die Verbindungsstege 19, den Rahmen 20 mit der Trägerstruktur 3 verbinden, aufgetrennt werden. Das Auftrennen kann manuell, beispielsweise mit einem Seitenschneider erfolgen, oder maschinell, beispielsweise mit einem Laser. Alternativ kann der Stapel zum Auftrennen in der Montagevorrichtung 10 verbleiben.

Figur 11 zeigt ein viertes Einzelteil 22. Das vierte Einzelteil 22 umfasst ein Elektrodenelement 5 und einen Rahmen 23, der das Elektrodenelement 5 einfasst und stützt. Der Rahmen 23 ist dabei ähnlich dem Rahmen 20 des zweiten Einzelteils 15 ausgebildet, insbesondere mit derselben Außenkontur und einer Justagenase 6. Das Elektrodenelement 5 weist zwei flügelförmige Abschnitte 24a, 24b auf, die entsprechend den flügelförmigen Abschnitten 18 der Trägerstruktur 3 ausgebildet sind. Von den flügelförmigen Abschnitten 24a, 24b geht jeweils bogenförmig eine Kontaktbahn 25a, 25b ab. Die beiden gegenüberliegenden flügelförmigen Abschnitte 24a, 24b sind über einen Verbindungssteg 26 miteinander verbunden. Im Rahmen 23 wird das Elektrodenelement 5 über mehrere Befestigungsstege 27 gehalten.

Entsprechend dem zweiten Einzelteil 15 ist das vierte Einzelteil 22 mittels Laserbearbeitung aus einem Vollblech herausgearbeitet. Das Blech besteht aus einem elektrisch leitenden Material. Ober- und Unterseite des vierten Einzelteils 22 sind zueinander planparallel, ebenso wie Unter- und Oberseite der seismischen Masse 4, des zweiten Einzelteils 15, des piezoelektrischen Elements 2 und des Abstandsmittels 9.

Der Verbindungssteg 26, siehe Figur 12, wird an einem Ende aufgetrennt, hier am Ende 28, welches am zweiten flügelförmigen Abschnitt 24b endet. Auf die Unterseite des ersten flügelförmigen Abschnitts 24a des Elektrodenelementes 5 wird ein elektrisch leitender Klebstoff 8b aufgetragen. Ebenso wird ein elektrisch leitfähiger Klebstoff auf die Unterseite des Verbindungssteges 26 aufgebracht. Auf die Unterseite des zweiten flügelförmigen Abschnitts 24b des vierten Einzelteils 22 wird hingegen ein nichtelektrisch leitender Klebstoff 8a aufgebracht.

Der schichtweise zusammengefügte Stapel aus seismischer Masse 4, Trägerstruktur 3 und piezoelektrischem Element 2 wird, falls dieser herausgenommen wurde, erneut in der Montagevorrichtung 10 positioniert. Danach wird das vierte Einzelteil 22 in der Montagevorrichtung 10 positioniert, wobei die Unterseite des vierten Einzelteils 22 mit dem aufgetragenen Klebstoff 8a, 8b der Trägerstruktur 3 und dem piezoelektrischen Element 2 zugewandt ist. Danach folgt ein Aneinanderpressen mittels des Presselementes 11 und ein Ausheizen des Klebers im Ofen in schon oben beschriebener Weise. Anschließend wird der gesamte zusammengefügte Stapel aus der Montagevorrichtung 14 entnommen.

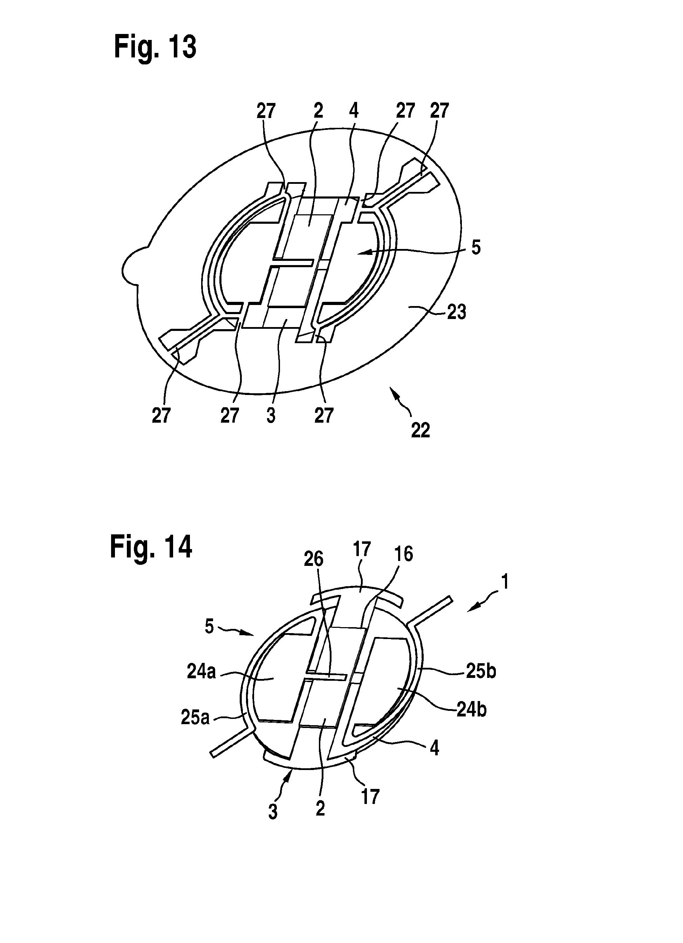

Den aus der Montagevorrichtung 10 entnommenen zusammengefügten Stapel aus seismischer Masse 4 - Trägerstruktur 3 - piezoelektrischem Element 2, und viertem Einzelteil 22 mit Elektrodenelement 5 zeigt Figur 13. Das Elektrodenelement 5 und der Außenring 23 werden nun voneinander getrennt, indem die Befestigungsstege 27 aufgetrennt werden.

Den gemäß der ersten Ausführungsform des erfindungsgemäßen Verfahrens hergestellten Energiewandlersystems 1 zeigt Figur 14. Über die Lagerabschnitte 17 der Trägerstruktur 3 lässt sich das Energiewandlersystem 1 schwingfähig lagern, beispielsweise in einem Gehäuse, das eine den Lagerabschnitten 17 entsprechende Nut aufweist. Durch Schwingen des Balkenförmigen Abschnitts 16 der Trägerstruktur 3 wird das piezoelektrische Element 2 verformt. Die Spannung, die durch die Verformung des piezoelektrischen Elementes 2 aufgebaut wird, kann an der Oberseite des piezoelektrischen Elementes 2 über den Verbindungssteg 26, den ersten flügelförmigen Abschnitt 24a und der zugeordneten Kontaktbahn 25a abgegriffen werden, an der Unterseite des piezoelektrischen Elementes 2 über den balkenförmigen Abschnitt 16, den flügelförmigen Abschnitt 18 der Trägerstruktur 3, dem zweiten flügelförmigen Abschnitt 24b des Elektrodenelementes 5 und der diesem zugeordneten Kontaktbahn 25b. Die seismische Masse 4 dient zur Einstellung der Resonanzfrequenz dieses schwingfähigen Systems.

Das derartig hergestellte Energiewandlersystem eignet sich beispielsweise als Bestandteil einer Stromversorgung von energetisch autarken Systemen, beispielsweise von Reifensensoren, die Reifentemperatur und/oder Reifendruck und/oder im Reifen auftretende Beschleunigungen messen.

Alternativ zur Verwendung eines Klebstoffes 8a, 8b zum Zusammenfügen der verschiedenen Einzelteile lässt sich auch ein Schweißprozess einsetzen, beispielsweise Laserschweißen oder Ultraschallschweißen. Des Weiteren kann anstatt einer kreisförmigen Außenkontur der Einzelteile 15, 22 und des Abstandsmittels 9 beispielsweise eine eckige Form, insbesondere quadratische Form gewählt werden. Die Montagevorrichtung 10 ist entsprechend anzupassen. Bei einer eckigen Außenkontur kann die Justagenase 6 entfallen. In einer weiteren Alternativ kann die Montagevorrichtung anstatt einer Justagenase einen oder mehrere Passstifte und das erste Einzelteil 15, das Abstandsblech 9 und viertes Einzelteil 22 eine entsprechende Anzahl von Löchern für ein Durchführen des Passstiftes aufweisen.

Alternativ können das erste Einzelteil 15, das Abstandsblech 9 und das vierte Einzelteil 22 aus einem Blech durch einen Stanzprozess hergestellt werden.

Alternativ kann das Anpressen der seismischen Masse 4, der Trägerstruktur 3, des piezoelektrischen Elementes 2 und des Elektrodenelementes 5 in nur einem einzigen Schritt mittels des Presselementes 11 erfolgen, einschließlich des Ausheizens des Klebers im Ofen. Auch das Freistellen der Trägerstruktur 3 vom Rahmen 20 kann grundsätzlich zu einem späteren Zeitpunkt erfolgen, insbesondere erst nach der Freistellung des Elektrodenelementes 5.

Das erfindungsgemäße Verfahren lässt sich auch für die parallele Herstellung einer Vielzahl von Energiewandlersystemen verwenden, was im Folgenden anhand einer zweiten Ausführungsform des erfindungsgemäßen Verfahrens beschrieben wird.

Gemäß der zweiten Ausführungsform sind zweites, drittes und viertes Einzelteil als großflächige planparallele Bleche 40, 41, 42 ausgebildet. Das zweite Einzelteil 40 umfasst eine Vielzahl von in einem Feld angeordneten Trägerstrukturen 3, die entsprechend der ersten Ausführungsform über Befestigungsstege (nicht sichtbar) an einem dem zweiten Einzelteil 40 zugeordneten Rahmen 43 befestigt sind. Entsprechend weist das dritte Einzelteil 41 von einem Rahmen 44 gehaltene Piezoelemente 2, das vierte Einzelteil 42 entsprechend von einem Rahmen 45 gehaltene Elektrodenelemente 5 auf.

Eine zweite Ausführungsform einer Montagevorrichtung 30 weist eine großflächige Grundplatte 47 mit einer entsprechend dem Feld angeordneten Vielzahl von Aussparungen 46 auf, die für die Aufnahme von ersten Einzelteilen, hier seismischen Massen 4, vorgesehen sind.

Für die Herstellung von Energiewandlersystemen 1 werden zunächst die seismischen Massen 4 in die Aussparungen 46 der Montagevorrichtung 30 eingesetzt, beispielsweise mittels Pick-and-Place-Technik, hier mittels eines Roboters, der eine seismische Masse 4 von einem Vorrat aufnimmt und dann in eine freie Aussparung 46 setzt. Eine weitere vorteilhafte Einbringungsform von seismischen Massen 4 in die Montagevorrichtung 30 ist das Aufschütten und Einrütteln des seismischen Massen 4 in die vorgesehenen Aussparungen 46.

Nachfolgend werden zweites Einzelteil 40, drittes Einzelteil 41 und viertes Einzelteil 42 auf der Montagevorrichtung 30 übereinander gestapelt. Zum korrekten Positionieren der Einzelteile 40, 41, 42 die Montagevorrichtung 30 als Positionierhilfengegenstück vier in den Ecken positionierte Justierbolzen 37 auf, und die Einzelteile 40, 41 und 42 dazu komplementär ausgebildete Durchgangsbohrungen 36. Vordem Übereinanderstapeln sind die jeweiligen Einzelteile 40, 41, 42 mit Klebstoff versehen, entsprechend der ersten Ausführungsform. Auf den durch Grundplatte 47 der Montagevorrichtung 30, zweites Einzelteil 40, drittes Einzelteil 41 und viertes Einzelteil 42 gebildeten Stapels wird ein als Abschlussplatte 31 ausgebildetes Presselement aufgesetzt. Die Abschlussplatte 31 weist ebenfalls Durchgangsbohrungen 36 auf, die eine Führung der Abschlussplatte 31 durch die Justierbolzen 37 ermöglichen.

Mittels der Abschlussplatte 31 wird der Stapel aus seismischen Massen 4, Trägerstrukturen 3, piezoelektrischen Elementen 2 und Elektrodenelementen 5 aneinander gepresst und zusammengefügt. Der Klebstoff wird in einem Ofen ausgeheizt. Nach dem Ausheizen und Entnehmen des zusammengefügten Stapels aus der Montagevorrichtung 30 werden die einzelnen Elektrodenelemente 5, Trägerstrukturen 3 und piezoelektrischen Elemente 2 von Ihren Tragrahmen 43, 44 und 45 frei gestellt. Auf diese Weise wird eine Vielzahl von Energiewandlersystemen 1, wie in der Figur 14 dargestellt, hergestellt.

## Patentansprüche

1. Verfahren zur Herstellung mindestens eines mechanisch-elektrischen Energiewandlersystems aus mehreren Einzelteilen, bei dem zumindest zwei Einzelteile (2, 3, 4, 15, 22, 40, 41, 42) in einer Montagevorrichtung (10, 30) positioniert und in der Montagevorrichtung (10, 30) in Fügebereichen (18, 24a, 24b) zusammengefügt werden,
wobei die Einzelteile (2, 3, 4, 15, 22, 40, 41, 42) mindestens ein piezoelektrisches Element (2), eine Trägerstruktur (3) und eine seismische Masse (4) umfassen,
**dadurch gekennzeichnet, dass**
die Trägerstruktur (3) und das piezoelektrische Element (2) mit einem elektrisch leitenden Klebemittel (8b) und einem elektrisch nicht leitenden Klebemittel (8a) zusammengefügt werden.

2. Verfahren nach Anspruch 1, wobei die Einzelteile weiterhin ein Elektrodenelement (5) aufweisen.

3. Verfahren nach Anspruch 1 oder 2, wobei die mehreren Einzelteile (2, 3, 4, 15, 22, 40, 41, 42) in der Montagevorrichtung (10, 30) schichtweise positioniert werden, so dass diese in Form eines Stapels übereinander liegen.

4. Verfahren nach Anspruch 3, wobei der Stapel folgende Reihenfolge der Einzelteile von unten nach oben aufweist:
seismische Masse (4), Trägerstruktur (3), piezoelektrisches Element (2), und gegebenenfalls Elektrodenelement (5).

5. Verfahren nach einem der vorhergehenden Ansprüche, wobei die Fügebereiche (18, 24a, 24b) der Einzelteile (2, 3, 4, 15, 22, 40, 41, 42) derart ausgebildet werden, dass bei Positionierung der Einzelteile (2, 4, 15, 22, 40, 41, 42) in der Montagevorrichtung (10, 30) die Fügebereiche (18, 24a, 24b) der Einzelteile (2, 3, 4, 15, 22, 40, 41, 42) in zueinander parallelen Ebenen liegen.

6. Verfahren nach einem der vorhergehenden Ansprüche, wobei die mehreren Einzelteile (2, 3, 4, 15, 22, 40, 41, 42) flächig mit einer zueinander im Wesentlichen planparallelen Unter- und Oberseite ausgebildet werden.

7. Verfahren nach einem der vorhergehenden Ansprüche, wobei einige oder sämtliche Einzelteile (15, 22, 40, 41, 42) zunächst mit einer übereinstimmenden Außenkontur ausgebildet und in der Montagevorrichtung (10) positioniert und zusammengefügt werden, und nach dem Zusammenfügen mindestens ein Einzelteil in seiner Außenkontur beschnitten wird.

8. Verfahren nach Anspruch 8, wobei die übereinstimmende Außenkontur der Innenkontur der Montagevorrichtung (10) entspricht.

9. Verfahren nach Anspruch 7 oder 8, wobei das mindestens eine zu beschneidende Einzelteil eine Sollschnittstelle aufweist, z. B. als Verbindungssteg.

10. Verfahren nach einem der Ansprüche 6 bis 8, wobei das Beschneiden der Außenkontur mechanisch oder mittels Laserschneiden erfolgt.

11. Verfahren nach einem der vorhergehenden Ansprüche, wobei die Einzelteile (15, 22, 40, 41, 42) mit einer Positionierhilfe (6, 36) zur Positionierung in der Montagevorrichtung (10) ausgebildet sind.

12. Verfahren nach Anspruch 11, wobei die Montagevorrichtung (10, 30) ein Positionierhilfegegenstück (7, 37) aufweist, das mit der Positionierhilfe (6, 36) der Einzelteile (2, 3, 4, 15, 22, 40, 41, 42) zusammenwirkt, z. B. komplementär zur Positionierhilfe (6, 36) ausgebildet ist.

13. Verfahren nach einem der vorhergehenden Ansprüche, wobei die Einzelteile (2, 3, 4, 15, 22, 40, 41, 42) mittels einer oder mehrerer der folgenden Fügetechniken verbunden werden: Schweißen, Laserschweißen, Ultraschallschweißen, Klebung mittels eines Klebemittels (8a ,8b).

14. Verfahren nach Anspruch 13, wobei zum Zusammenfügen der mindestens zwei Einzelteile (2, 3, 4, 15, 22, 40, 41, 42) mittels eines Klebemittels (8a, 8b) zunächst das Klebemittel (8a, 8b) in dem Fügebereich (18, 24a, 24b) eines oder beider Einzelteile (2, 3, 4, 15, 22, 40, 41, 42) aufgetragen wird, und dann die Einzelteile (2, 3, 4, 15, 22, 40, 41, 42) durch Aneinanderpressen zusammengefügt werden, wobei das Aneinanderpressen mittels eines Presselementes (11, 31), z. B. durch die Gewichtskraft des Presselementes (11, 31), erfolgt.

15. Verfahren nach Anspruch 13 oder 14, wobei zum Zusammenfügen der mindestens zwei Einzelteile (2, 15) mittels des Klebemittels (8a, 8b) vor dem Zusammenfügen ein Abstandsmittel (9) in die Montagevorrichtung (10) eingesetzt wird, mittels dem ein Abstand zwischen den beiden Einzelteilen (2, 15) festgelegt wird und/oder insbesondere beim Zusammenfügen ein Mindestabstand zwischen den beiden Einzelteilen (2, 15) aufrechterhalten wird.

16. Verfahren nach einem der vorhergehenden Ansprüche, wobei mehrere mechanisch-elektrische Energiewandlersysteme (1) gleichzeitig hergestellt werden, indem die Einzelteile (40, 41, 42) jeweils als nebeneinander angeordnete, zueinander beabstandete, identische Teilbereiche oder Teilstrukturen (2, 3, 4, 15, 22) aufweisen, die in einem gemeinsamen Fügevorgang jeweils miteinander verbunden werden zu den mehreren Energierwandlersystemen (1), die nachfolgend vereinzelt werden.

17. Verfahren nach einem der vorhergehenden Ansprüche, wobei vor dem Zusammenfügen von Trägerstruktur (3) und piezoelektrischem Element (2) ein Abstandsblech in die Montagevorrichtung (10) eingebracht wird.

18. Mechanisch-elektrisches Energiewandlersystem, hergestellt durch ein Verfahren nach einem der vorhergehenden Ansprüche, bestehend aus mehreren Einzelteilen (2, 3, 4, 15, 22, 40, 41, 42), wobei die Einzelteile (2, 3, 4, 15, 22, 40, 41, 42) mindestens
- ein piezoelektrisches Element (2),
- eine Trägerstruktur (3) und
- eine seismische Masse (4)
umfassen,
**dadurch gekennzeichnet dass**
die Trägerstruktur (3) und das piezoelektrische Element (2) mit einem elektrisch leitenden Klebemittel (8b) und einem elektrisch nicht leitenden Klebemittel (8a) zusammengefügt sind.

## Claims

1. Method for producing at least one mechanical-electrical energy conversion system consisting of multiple individual parts, in which
at least two individual parts (2, 3, 4, 15, 22, 40, 41, 42) are positioned in an assembly device (10, 30) and are joined together in joining areas (18, 24a, 24b),
wherein the individual parts (2, 3, 4, 15, 22, 40, 41, 42) comprise at least one piezoelectric element (2), a support structure (3) and a seismic mass (4),
**characterized in that**
the support structure (3) and the piezoelectric element (2) are joined together by an electrically conductive adhesive (8b) and an electrically nonconductive adhesive (8a).

2. Method according to Claim 1, wherein the individual parts also comprise an electrode element (5).

3. Method according to Claim 1 or 2, wherein the multiple individual parts (2, 3, 4, 15, 22, 40, 41, 42) are positioned in the assembly device (10, 30) in layers, so that they lie one on top of the other in the form of a stack.

4. Method according to Claim 3, wherein the stack has the following sequence of individual parts from bottom to top:
the seismic mass (4), the support structure (3), the piezoelectric element (2), and optionally the electrode element (5).

5. Method according to one of the preceding claims, wherein the joining areas (18, 24a, 24b) of the individual parts (2, 3, 4, 15, 22, 40, 41, 42) are formed in such a way that, during the positioning of the individual parts (2, 3, 4, 15, 22, 40, 41, 42) in the assembly device (10, 30), the joining areas (18, 24a, 24b) of the individual parts (2, 3, 4, 15, 22, 40, 41, 42) lie in planes that are parallel to one another.

6. Method according to one of the preceding claims, wherein the multiple individual parts (2, 3, 4, 15, 22, 40, 41, 42) are formed in a planar manner with an underside and an upper side that are substantially plane-parallel to one another.

7. Method according to one of the preceding claims, wherein some or all of the individual parts (15, 22, 40, 41, 42) are initially formed with a matching outer contour and are positioned and joined together in the assembly device (10), and after being joined together at least one individual part is trimmed in its outer contour.

8. Method according to Claim 7, wherein the matching outer contour corresponds to the inner contour of the assembly device (10).

9. Method according to Claim 7 or 8, wherein the at least one individual part to be trimmed has a predetermined cutting location, for example as a connecting web.

10. Method according to one of Claims 6 to 8, wherein the trimming of the outer contour is performed mechanically or by means of laser cutting.

11. Method according to one of the preceding claims, wherein the individual parts (15, 22, 40, 41, 42) are formed with a positioning aid (6, 36) for the positioning in the assembly device (10).

12. Method according to Claim 11, wherein the assembly device (10, 30) has a positioning aid counterpart (7, 37), which interacts with the positioning aid (6, 36) of the individual parts (2, 3, 4, 15, 22, 40, 41, 42), for example is formed so as to complement the positioning aid (6, 36).

13. Method according to one of the preceding claims, wherein the individual parts (2, 3, 4, 15, 22, 40, 41, 42) are connected by means of one or more of the following joining techniques: welding, laser welding, ultrasonic welding, adhesive bonding by means of an adhesive (8a, 8b).

14. Method according to Claim 13, wherein, for the joining together of the at least two individual parts (2, 3, 4, 15, 22, 40, 41, 42) by means of an adhesive (8a, 8b), firstly the adhesive (8a, 8b) is applied in the joining region (18, 24a, 24b) of one or both individual parts (2, 3, 4, 15, 22, 40, 41, 42), and then the individual parts (2, 3, 4, 15, 22, 40, 41, 42) are joined together by being pressed one against the other, the pressing of one against the other being performed by means of a pressing element (11, 31), for example by the force of the weight of the pressing element (11, 31).

15. Method according to Claim 13 or 14, wherein, for the joining together of the at least two individual parts (2, 15) by means of the adhesive (8a, 8b), a spacer (9) is inserted into the assembly device (10) before the joining-together operation, by means of which spacer a distance between the two individual parts (2, 15) is established and/or a minimum distance between the two individual parts (2, 15) is maintained, in particular during the joining-together operation.

16. Method according to one of the preceding claims, wherein multiple mechanical-electrical energy conversion systems (1) are produced at the same time, in that the individual parts (40, 41, 42) respectively have identical partial regions or partial structures (2, 3, 4, 15, 22) that are arranged next to one another and are kept at a distance from one another, which are respectively connected to one another in a common joining operation to form the multiple energy conversion systems (1), which are subsequently individually separated.

17. Method according to one of the preceding claims, wherein, before the joining together of the support structure (3) and the piezoelectric element (2), a spacer sheet is introduced into the assembly device (10).

18. Mechanical-electrical energy conversion system, produced by a method according to one of the preceding claims, consisting of multiple individual parts (2, 3, 4, 15, 22, 40, 41, 42), wherein the individual parts (2, 3, 4, 15, 22, 40, 41, 42) comprise at least
- a piezoelectric element (2),
- a support structure (3) and
- a seismic mass (4),
**characterized in that** the support structure (3) and the piezoelectric element (2) are joined together by an electrically conductive adhesive (8b) and an electrically nonconductive adhesive (8a).

## Revendications

1. Procédé de fabrication d'au moins un système de conversion d'énergie électrique en énergie mécanique constitué de plusieurs parties distinctes, dans lequel au moins deux parties distinctes (2, 3, 4, 15, 22, 40, 41, 42) sont placées dans un ensemble de montage (10, 30) et sont assemblées dans des zones de jonction (18, 24a, 24b) de l'ensemble de montage (10, 30),
les parties distinctes (2, 3, 4, 15, 22, 40, 41, 42) comprenant au moins un élément piézoélectrique (2), une structure porteuse (3) et une masse sismique (4), **caractérisé en ce que**
la structure porteuse (3) et l'élément piézoélectrique (2) sont assemblés au moyen d'un adhésif électriquement conducteur (8b) et d'un adhésif non électriquement conducteur (8a).

2. Procédé selon la revendication 1, dans lequel les parties distinctes présentent en outre un élément d'électrode (5).

3. Procédé selon les revendications 1 ou 2, dans lequel les différentes parties distinctes (2, 3, 4, 15, 22, 40, 41, 42) sont placées dans l'ensemble de montage (10, 30) en couches superposées el les plaçant les unes au-dessus des autres pour former un empilement.

4. Procédé selon la revendication 3, dans lequel l'empilement présente du bas vers le haut la succession suivante de parties distinctes : masse sismique (4), structure porteuse (3), élément piézoélectrique (2) et éventuellement élément d'électrode (5).

5. Procédé selon l'une des revendications précédentes, dans lequel les parties de jonction (18, 24a, 24b) des parties distinctes (2, 3, 4, 15, 22, 40, 41, 42) sont configurées de telle sorte que lorsque les parties distinctes (2, 3, 4, 15, 22, 40, 41, 42) sont placées dans l'ensemble de montage (10, 30), les parties de jonction (18, 24a, 24b) des parties distinctes (2, 3, 4, 15, 22, 40, 41, 42) sont situées dans des plans parallèles.

6. Procédé selon l'une des revendications précédentes, dans lequel les différentes parties distinctes (2, 3, 4, 15, 22, 40, 41, 42) sont plates et présentent un côté inférieur et un côté supérieur situés essentiellement dans des plans parallèles.

7. Procédé selon l'une des revendications précédentes, dans lequel certaines parties distinctes ou toutes les parties distinctes (15, 22, 40, 41, 42) sont d'abord formées avec un contour extérieur en correspondance et sont placées et jointes dans l'ensemble de montage (10), au moins une partie distincte ayant son contour extérieur découpé après la jonction.

8. Procédé selon la revendication 7, dans lequel le contour extérieur en correspondance correspond au contour intérieur de l'ensemble de montage (10).

9. Procédé selon les revendications 7 ou 8, dans lequel la ou les parties distinctes à découper présentent un emplacement de découpe de consigne, par exemple configuré comme traverse de liaison.

10. Procédé selon l'une des revendications 6 à 8, dans lequel la découpe du contour extérieur s'effectue mécaniquement ou au laser.

11. Procédé selon l'une des revendications précédentes, dans lequel les parties distinctes (15, 22, 40, 41, 42) sont configurées avec un accessoire de positionnement (6, 36) qui permet de les positionner dans l'ensemble de montage (10).

12. Procédé selon la revendication 11, dans lequel l'ensemble de montage (10, 30) présente une pièce complémentaire (7, 37) d'accessoire de positionnement qui coopère avec l'accessoire de positionnement (6, 36) des parties distinctes (2, 3, 4, 15, 22, 40, 41, 42) et par exemple configurée de manière complémentaire par rapport à l'accessoire de positionnement (6, 36).

13. Procédé selon l'une des revendications précédentes, dans lequel les parties distinctes (2, 3, 4, 15, 22, 40, 41, 42) sont raccordées au moyen d'une ou plusieurs des techniques de jonction suivantes : soudage, soudage au laser, soudage aux ultrasons, collage au moyen d'un adhésif (8a, 8b).

14. Procédé selon la revendication 13, dans lequel pour l'assemblage des deux ou plusieurs parties distinctes (2, 3, 4, 15, 22, 40, 41, 42) au moyen d'un adhésif (8a, 8b), l'adhésif (8a, 8b) est d'abord appliqué dans la zone de jonction (18, 24a, 24b) d'une ou des deux parties distinctes (2, 3, 4, 15, 22, 40, 41, 42), des parties distinctes (2, 3, 4, 15, 22, 40, 41, 42) étant ensuite assemblées en étant repoussées l'une contre l'autre, l'opération de poussée l'une contre l'autre s'effectuant au moyen d'un élément de poussée (11, 31), par exemple sous l'action du poids propre de l'élément de poussée (11, 31).

15. Procédé selon les revendications 13 ou 14, dans lequel pour l'assemblage des deux ou plusieurs parties distinctes (2, 15) au moyen d'un adhésif (8a, 8b), un moyen d'écartement (9) est placé dans l'ensemble de montage (10) avant l'assemblage et définit une distance entre les deux parties distinctes (2, 15) et/ou, en particulier lors de l'assemblage, maintient une distance minimale entre les deux parties distinctes (2, 15) .

16. Procédé selon l'une des revendications précédentes, dans lequel plusieurs systèmes (1) de conversion d'énergie électrique en énergie mécanique sont fabriqués simultanément par le fait que les parties distinctes (40, 41, 42) présentent chacune des parties identiques ou des structures partielles (2, 3, 4, 15, 22) qui sont disposées l'une à côté de l'autre, maintenues à distance l'une de l'autre et reliées les unes aux autres dans une opération de jonction commune pour former les différents systèmes (1) de conversion d'énergie qui sont ensuite séparés un à un.

17. Procédé selon l'une des revendications précédentes, dans lequel avant l'assemblage de la structure porteuse (3), l'élément piézoélectrique (2), une tôle d'écartement est placée dans l'ensemble de montage (10).

18. Système de conversion d'énergie électrique en énergie mécanique fabriqué par un procédé selon l'une des revendications précédentes et constitué de plusieurs parties distinctes (2, 3, 4, 15, 22, 40, 41, 42), les parties distinctes (2, 3, 4, 15, 22, 40, 41, 42) comprenant au moins un élément piézoélectrique (2), une structure porteuse (3) et une masse sismique (4), **caractérisé en ce que**
la structure porteuse (3) et l'élément piézoélectrique (2) sont assemblés au moyen d'un adhésif électriquement conducteur (8b) et d'un adhésif non électriquement conducteur (8a).
